# EUROPEAN PATENT SPECIFICATION

(11) **EP 1 665 530 B1**
(45) Date of publication and mention of the grant of the patent: **21.11.2007**
(21) Application number: 04769221.5
(22) Date of filing: 26.08.2004
(51) Int. Cl.: H03K 3/356

(54) **A STATIC LATCH**
STATISCHES LATCH
VERROU STATIQUE

(30) Priority: 03.09.2003 EP 03103273
(43) Date of publication of application: 07.06.2006
(73) Proprietor: NXP B.V., 5656 AG Eindhoven (NL)
(72) Inventor: WIELAGE, Paul, Redhill, Surrey RH1 5HA (GB)
(74) Representative: White, Andrew Gordon
(86) International application number: PCT/IB2004/002807
(87) International publication number: WO 2005/022746

(56) References cited:
- EP-A- 0 926 825
- US-B1- 6 348 824

## Description

Latches are well known in the art and are often used for buffering or temporarily storing data. A standard static latch operates in two states. In its first state, it connects an input of the latch to its respective output and a complementary input of the latch to its corresponding complementary output. The input data signal and its complementary are free to propagate to their respective outputs. When the latch is in its second state, it disconnects the respective inputs of the latch from their respective outputs and the respective last output states of the latch are held on their respective outputs.

However, conventional latches utilize a relatively large number of components. Therefore, the required semiconductor chip area and the cost of fabrication are high. Furthermore, they consume relatively large amounts of power.

Examples of conventional CMOS static latches are shown in Figures 1a and 2 and in Fig 2 of US 6 348 824 B1.

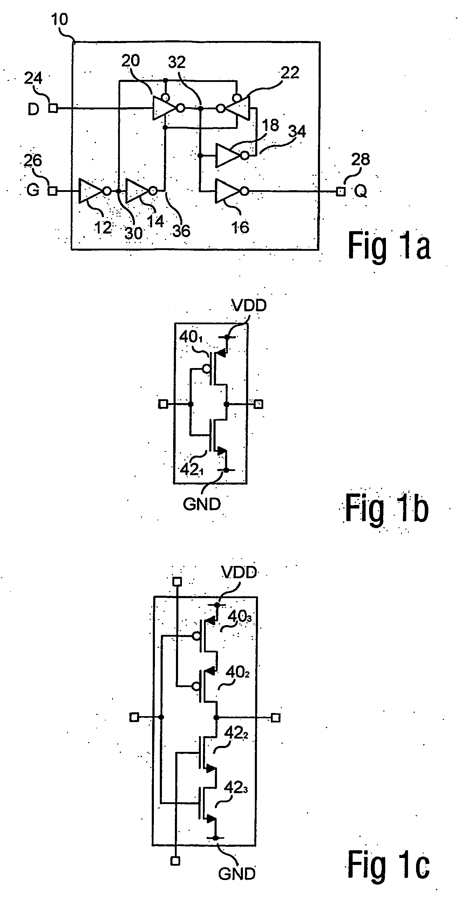

The static latch 10 of Figure 1a comprises four inverters 12, 14, 16, 18, two tri-state inverters 20, 22 and three input/output terminals 24, 26, 28.

The first inverter 12 has an input that functions as an input control terminal 26, carrying an input control signal G, for the latch 10 and an output 30 that is connected to the input of the second inverter 14. The first tri-state inverter 20 has an input that functions as a data input terminal 24, carrying an input data signal D, of the latch 10 and an output 32 that is connected to the inputs of the third and fourth inverters 16, 18 and to the output of the second tri-state inverter 22. The third inverter 16 has an output that functions as a data output terminal 28, carrying an output data signal Q, of the latch 10. The fourth inverter 18 has an output 34 that is connected to the input of the second tri-state inverter 22. The output 30 of the first inverter 12 is also connected to respective first control terminals of the two tri-state inverters 20, 22. The output 36 of the second inverter 14 is connected to respective second control terminals of the two tri-state inverters 20, 22.

When the latch 10 is enabled, i.e. the enable signal G provided on the control terminal 26 is high, G=1, the latch 10 is effectively transparent and the input data D provide on the data input terminal 24 is transferred onto the output terminal 28 of the latch 10. Whilst the latch 10 is enabled, any changes to the input data D will be reflected on the output terminal 28. When the latch 10 is disabled, i.e. the enable signal, G=0, on the control terminal 26, the latch 10 holds the current value of the output data Q on the output terminal 28 irrespective of changes to the input data D, that is the latch 10 is no longer transparent and the data input terminal 24 is effectively disconnected from the data output terminal 28.

The latch 10 operates to transfer the data input D onto the output terminal 28 when enabled, i.e. when G is high, and to maintain the present value of the output data Q when disabled, i.e. when G is low. The first and second tri-state inverters 20, 22 are triggered by the enable signal G and its complement GN, which are respectively generated by the second and first inverters 12, 14, such that when the latch 10 is enabled, the tri-state inverters 20, 22 drive the third and fourth inverters 16, 18 such that the input data D is propagated onto the output terminal 28. When disenabled, the value of the output data Q is maintained at it current value irrespective of the value of the input data D.

The second tri-state inverter 22 and the fourth inverter 18 effectively form a holding circuit for maintaining the current value of the output when the first tri-state inverter 20 is disabled, G=0, i.e. the latch 10 is disabled. When the latch 10 is enabled, G=1, the first tri-state inverter 20 is enabled and inverts the input data D, and outputs it compliment DN. The inverted input data DN is then inverted by the third inverter 16 to give the output data Q on the output terminal 28.

When the first tri-state inverter 20 is disabled, G=0, the output 32 of the first tri-state inverter 22 is disabled and a high impedance, i.e. an open circuit, is presented on the output 32. The first tri-state inverter 20 is effectively disconnected and the fourth inverter 18 provides the previous value of the input data, D(-1) onto the input 34 of the second tri-state inverter 22. When the latch 10 is disabled, i.e. GN=1, the second tri-state inverter 22 is enabled and the previous value of the inverted input data DN(-1) is output from the second tri-state inverter 22. This is then provided on the input 32 of the third inverter 16, where it is inverted and the previous value of the data input D(-1) is generated on the output terminal 28 of the latch 10.

As long as the latch 10 is disenabled, i.e. G=0, and hence the first tri-state inverter 20 is disenabled and the second tri-state inverter 22 is enabled, the current value of the input data D will be provided on the input 34 of the second tri-state inverter 22 and this current value will be maintained on the output terminal 28 irrespective of changes of the signal D on the input terminal 24.

All four inverters may be standard CMOS inverters. Figure 1b illustrates an example of a standard CMOS inverter, such as those illustrated in Figure 1a, that comprises a PMOS transistor 40₁ and an NMOS transistor 42₁. The respective gates and drains of the PMOS and NMOS transistors 40, 42 are connected together to form respective input and output terminals of the inverter. The source of the PMOS transistor is connected to a positive power supply rail VDD and the source of the NMOS transistors is connected to a negative supply rail GND.

Figure 1c illustrates an example of a standard CMOS tri-state inverter, such as those illustrated in Figure 1a, that comprises first and second PMOS transistors 40₂, 40₃ and first and second NMOS transistors 42₂, 42₃. The respective gates of the second PMOS and second NMOS transistors 40₃, 42₃ are connected together to form the input terminal of the tri-state inverter. The source of the second PMOS transistor 40₃ is connected to the positive supply VDD and the source of the second NMOS transistor is connected to the negative supply GND.

The respective drains of the first PMOS and first NMOS transistors 40₂, 42₂ are connected together to form the output terminal of the tri-state inverter. The source of the first PMOS transistor 40₂ is connected to the drain of the second PMOS transistor 40₃ and the source of the first NMOS transistor 42₂ is connected to the drain of the second NMOS transistor 42₃. The gate of the first PMOS transistor acts as a first control terminal for the tri-state inverter and the gate of the first NMOS transistor acts as a second control terminal for the tri-state inverter.

Referring to Figure 1a, it can clearly be seen that such a latch 10 requires both the enable control signal G and it complement GN for operation of the tri-state inverters 20, 22. As can be readily deduced from Figures 1b and 1c, the latch 10 of Figure 1a comprises a total of sixteen NMOS and PMOS transistors and therefore suffers from the disadvantage of having a large cell size and high power consumption: especially given the fact that PMOS transistors have to be almost three times the physical size of NMOS transistors in order the match current handling capabilities.

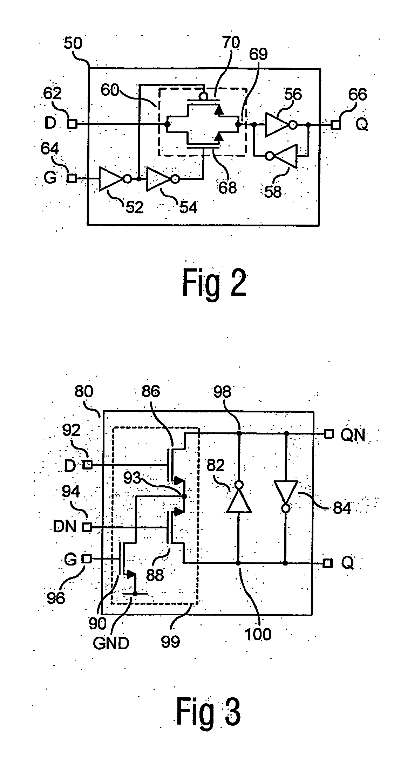

Figure 2 illustrates an alternative conventional static latch. This latch 50 comprises four inverters 52,54,56,58, a transmission circuit 60 and three input/output terminals 62,64,66.

All four inverters 52-58 in this Figure 2 may be standard CMOS inverters of the type illustrated in Figure 1b. Inverters 52 and 54 correspond to the respective inverters 12 and 14 of Figure 1a.

The transmission circuit 60 comprises an NMOS transistor 68 and a PMOS transistor 70 that have their respective drain terminals and source terminals connected together. The common drain terminals form the data input terminal 62, carrying an input data signal D, of the latch 50. The common source terminals 69 are connected to the respective input and output terminals of the inverters 56 and 58. The respective output and input terminals of the inverters 56 and 58 are connected together and form the data output terminal 62, carrying an output data signal Q, of the latch 50. Therefore, inverters 56 and 58 are connected in a back-to-back manner. The gate terminal of the PMOS transistor 70 is connected to the output of the first inverter 52 and receives the inverted enable signal GN. The gate terminal of the NMOS transistor 68 is connected to the output of the second inverter 54 and receives the enable signal G.

The transmission circuit 60 of the latch 50 operates to transmit the input data D onto the output terminal 66 when enabled. When disabled the input data is not transmitted. The inverter 58, having its input terminal connected to the output terminal 66 of the latch 60 and its output terminal connected to, among others, the common source terminals 69 of the transmission circuit 60, provides a feedback loop. This feedback loop ensures that when the transmission circuit 60 is disabled, the value of the output data Q is held at its present value irrespective of changes to the input data D.

However, as in the case of the latch 10 of Figure 1a, the latch 50 requires both the enable signal G and its complement GN. Furthermore, the transmission circuit 60 when it is transparent, i.e. enabled, exhibits a direct path from the input terminal 62 of the transmission circuit 60 to the common source output terminals 69 of the transmission circuit 60. This direct path causes excessive noise on the input data D when the input data D changes state. Further the transmission circuit 60 includes both a PMOS and an NMOS transistor. Since PMOS transistors are nearly three times as large as their equivalent NMOS transistors, the inclusion of PMOS transistors therefore disadvantageously increases the required cell area. Although the latch 50 of Figure 2 requires six transistors less than the latch 10 of Figure 1a, the latch 50 of Figure 2 still nevertheless requires a relatively large cell area.

Further information about latches, flip-flops and the like can be found in William J. Dally, John W. Poulton, "Latches and Flip-Flops" in Chapter 12 of "Digital systems engineering", 1999 and US Patent No. 5789956.

Thus, as illustrated by Figures 1 and 2, in a typical CMOS static latch, a total of between ten and sixteen MOSFETs are utilized. The large number of MOSFET devices required for each latch 10,50 results in exceptionally large cell areas, which is a disadvantage. Furthermore, as is clear from the latches 10,50 illustrated in Figures 1 and 2, operation of these latches 10, 50 requires both the enable signal G and its complement GN, which is another disadvantage. Therefore, in order to generate these signals G, GN, four additional MOSFETs, i.e. two additional inverters 12,14, are required.

The object of the present invention is to reduce the packing density and reduce the cell area of a device incorporating a plurality of static latches.

It is therefore desirable to reduce the number of components by providing latch circuitry, which does not require the complement GN of the enable signal G.

The object of the present invention is achieved in accordance with a circuit as defined in Claim 1.

The latch therefore does not require both the enable signal G and its complement GN. The number of components can be reduced, thus reducing the cell area of any device incorporating these latches. Furthermore, the latch according to the present invention has low clock load, reduced sub-threshold leakage, improved speed and reduced power consumption.

These and other aspects of the invention will be apparent from and elucidated with reference to the embodiments described hereinafter.

Embodiments of the present invention will now be described with reference to the accompanying drawings in which:
Figures 1a-1c illustrate schematic diagrams of an example of a conventional static latch;
Figure 2 illustrates a schematic diagram of another example of a conventional static latch;
Figure 3 illustrates a schematic diagram of the latch according to an embodiment of the present invention;
Figure 4 illustrates a layout of the latch of Figure 3;
Figure 5 illustrates a shift register comprising two latches according to the embodiment of the present invention connected in series;
Figure 6 illustrates the waveforms for the shift register shown in Figure 5;
Figure 7 illustrates a circuit for converting a single rail data signal to dual rail signals appropriate for the latch according to the embodiment of the present invention;
Figure 8 illustrates the waveforms of the single to dual rail conversion circuit of Figure 7;
Figure 9 is a schematic diagram of an alternative embodiment of the present invention;
Figure 10 is a schematic diagram of a further alternative embodiment of the present invention;
Figure 11 is a schematic diagram of the latch of the present invention implementing a logic function;
Figure 12 illustrates a shift register comprising the latches of the present invention; and
Figure 13 illustrates an alternative shift register comprising the latches of the present invention.

An embodiment of the present invention will now be described with reference to Figure 3. The latch 80 comprises two inverters 82,84, three NMOS transistors 86,88,90 and five input/output terminals 92,94,96,98,100.

The two inverters 82,84 in this Figure 3 may be standard CMOS inverters of the type illustrated in Figure 1b. Inverters 82 and 84 correspond to the respective inverters 58 and 56 of Figure 2.

The first and second transistors 86, 88 have their respective source terminals 93 connected together. These common source terminals 93 are also connected to the drain terminal of the third transistor 90. The drain terminal of the first transistor 86 forms a data output terminal 98 which carries the latch's complement data output signal QN. The drain terminal of the second transistor 88 forms a data output terminal 100 which carries the latch's data output signal Q. The source terminal of the third transistor 90 is connected to the negative supply rail GND. The three NMOS transistors 86, 88, 90 are collectively grouped together to form an input circuit 99 to the latch 80. The two inverters 82,84 are connected in a back-to-back manner between the latches two output terminals 98, 100. The respective gate terminals of the first and second transistors 86,88 respectfully correspond to the two data input terminals 92 and 94. The two data input terminals 92 and 94 respectfully carry the complementary input data signals D and DN. The gate terminal of the third transistor 90 corresponds to an input control terminal 96 which carries the input control signal G.

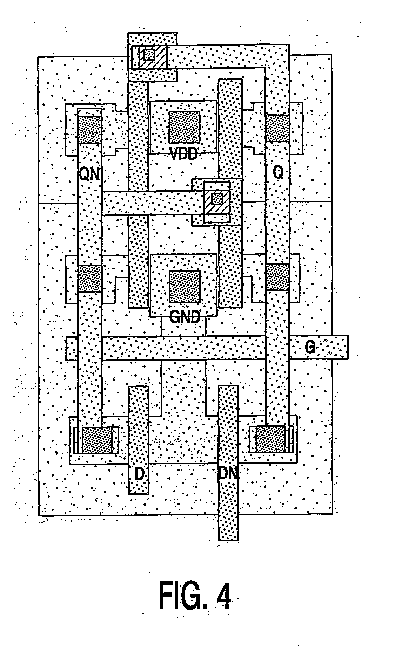

The layout of the latch 80 of Figure 3 is shown in Figure 4.

The operation of the latch 80 of Figures 3 and 4 is very simple. When the enable signal G on the control terminal 96 is high the latch is transparent, that is the respective complementary input signals D, DN on the respective input terminals 92, 94 can freely propagate to their respective output terminals 100,98 which carry the complementary output signals QN, Q. If the enable signal G on the control terminal 96 is low, the complementary input signals D and DN are disconnected from the output terminals 98, 100. In this state, the hold state, the complementary output signals Q and QN of the latch 80 hold their last value. In this hold state, the complementary inputs D and DN are not allowed to be simultaneously high otherwise the state of the latch 80 is destroyed.

The truth table for the latch 80 of Figure 3 is shown in Table I below.

**Table I. Functional behavior of the latch**

| **D** | **DN** | **G** | **Q** | **QN** |
|---|---|---|---|---|
| 1 | 1 | - | Undefined | |
| - | - | 0 | Q(-1) | QN(-1) |
| 1 | 0 | 1 | 1 | 0 |
| 0 | 1 | 1 | 0 | 1 |

The data input signals and output signals are presented above in both true and complementary form. Of course, as can be appreciated, when the latch 80 is in the hold state, i.e. the enable signal G = 0, a simultaneous high level on D and DN would, in practice, be avoided. Otherwise the state of the latch 80 is lost.

The latch state changes by forcing a logic '0' on either of the output terminals 98, 100. This principle is often used in SRAM memory cells.

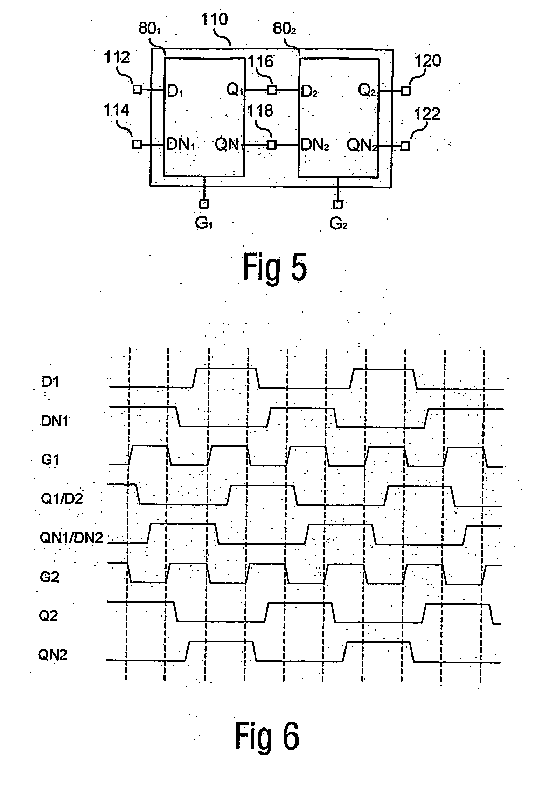

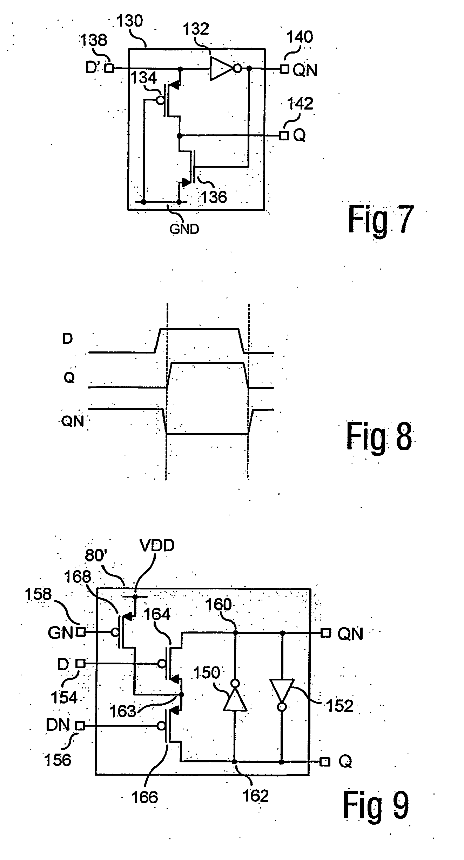

In accordance with the embodiments of the present invention, ensuring that the complementary input signals D, DN are never simultaneously high when the latch 80 is in its hold state, i.e. when the latch 80 is disabled, can be guaranteed in at least two ways in which the complementary input signals D and DN are connected to the complementary outputs terminals of another, previous, latch cell (as described in more detail below, with reference to Figure 5), or the two complementary input signals D and DN are derived from a single rail signal D' by means of an input stage described in more detail below with reference to Figure 7.

A comparison of the seven-transistor latch 80 of the present invention with the conventional latch 10 shown in Figure 1a is given in Table II below.

**Table II Comparison of the proposed latch of Figure 3 with the conventional latch of Figure 1a**

| | **Latch of present invention** | **Latch with 3-state inverters** | |
|---|---|---|---|
| **principle** | static | std cell latch | |
| **Area** | 4.7 | 18.2 | µm² |
| **Delay** | 125 | 165 | ps |
| **Retention time** | static | static | µs |
| **D (DN) input cap** | 2 x 0.64 | 2.9 | fF |
| **G input cap** | 0.68 | 2.5 | fF |
| **Energy (clock only)** | 0.99 | 17 | nW/MHz |
| **Energy (100% data+clock)** | 22 | 61 | nW/MHz |

As is clear from Table II above, the size of the latch 80 according to the preferred embodiment of the present invention is greatly improved over the conventional tri-state inverter latch 10 of Figure 1a. Its size is reduced by approximately 75%. With respect to the delay measurement carried out in the comparisons listed in Table II, two of the respective latches 80 were connected in series, as shown in Figure 5. The results in Table II illustrate that significant improvements were achieved in reducing the delay from 165ps to 125ps. The capacitance on the input data terminals 92,94 and the input control terminal 96 is also considerably less than that of the conventional tri-state inverter latch 10. Further significant improvements were achieved in reducing the power consumption of the latch 80. The results in Table II show reduced energy expended with the clock only and also with the data and clock.

The latch 80 according to the embodiment of the present invention is especially useful in FIFO modules. Such FIFOs are used in digital systems-on-a-chip for the storage of intermediate data when it is on its way for further signal processing. If the clock signals are generated with self-timed circuits, for example as disclosed in the MOUSETRAP FIFO Montek Singh and Steven M. Nowick, "MOUSETRAP: Ultra-High-Speed Transition-Signaling Asynchronous Pipelines", in IEEE ICCD 2001 concept, a FIFO comprising the latch 80 according to the embodiment of the present invention can be realized without the presence of a global clock signal. The MOUSETRAP FIFO is asynchronous and therefore, reading and writing does not need to happen synchronously. Hence, the MOUSETRAP FIFO is a perfect storage buffer in a clock domain crossing. A MOUSETRAP FIFO incorporating the latch 80 of the preferred embodiment of the present invention is a very efficient implementation of the state elements. The improved efficiency is due to the small cell size of the latch 80 of the embodiment of the present invention and the fact that only one polarity of the enable signal G is required for its transparent and hold modes of operation. As shown in Figures 1a and 2, a typical latch 10,50 requires both the enable signal G and its complement GN.

Furthermore, the latch 80 according to the embodiment at the present invention has an advantage in that it may be used in a low voltage, i.e. 3 volts or less, environment since the input signals D, DN, G to the latch 80 only need to overcome one transistor threshold voltage Vt in order to switch on their respective transistors.

Figure 5 shows a chain of first and second latches 80₁, 80₂ of the type illustrated in Figure 3 that are operatively connected to form a simple shift-register 110. Although, for the purposes of our explanation here, two latches 80₁, 80₂ are shown, it can be appreciated that any number 'N' of latches 80 may be connected for chains of arbitrary length. Thus, among others, a shift-register and a FIFO depending on the control of the latches 80N can be realized.

Each of the latches 80₁, 80₂ comprises complementary data input terminals, complementary data output terminals and a single input control terminal.

The first latch 80₁ receives respective complementary input data signals D₁, DN₁ on its respective complementary data input terminals 112, 114 and provides respective complementary output data signals Q₁, QN₁ on its respective complementary data output terminals 116, 118. The second latch 80₂ receives respective complementary input data signals D₂, DN₂ on its respective complementary data input terminals 116, 118 and provides respective complementary output data signals Q₂, QN₂ on its respective complementary data output terminals 120, 122. The complementary data output terminals 116, 118 of the first latch 80₁ are directly connected to, and thus form, the complementary data input terminals 116, 118 of the second latch 80₂. Therefore, the complementary output data signals Q₁, QN₁ of the first latch 80₁ serve as the complementary input data signals D₂, DN₂ of the second latch 80₂.

As shown in the waveforms of Figure 6, the complementary input data signals D₁, DN₁ of the first latch 80₁ are shifted through the register out towards the complementary data output terminals 120, 122 of the second latch 80₂.

In Figure 6 various waveforms are shown that correspond to a shift-register 110 application. The shift-register 110 behavior is realized when the enable signal G of the even latches in the chain is the complement of the odd latches. Therefore, in such a realization, a pair of consecutive latches 80₁, 80₂ in the chain forms a master/slave flip-flop.

It is noted that data output signals Q and QN of the latch 80 are never high at the same time. This is always the case because it requires a transition to a logic '0' on one data input terminal before the other data input terminal changes to a logic '1' after an inverter delay.

When the latch 80 is in the hold state, i.e. G=0, it is necessary that the input data D and its complement DN are not both high at the same time when switching from D=1,DN=0 to D=0,DN=1, since this would corrupt the contents of the latch. As illustrated in Figure 5, if the latch 80 of the preferred embodiment of the present invention is connected in series, D=1 and DN=1 never occurs. However, it is necessary to ensure that D=1 and DN=1 does not occur for the first latch 80₁ in the chain.

For this reason the circuit given in Figure 7 can be utilized with the latch 80 of the preferred embodiment of the present invention. The circuit of Figure 7 is a simple conversion circuit 130 for translating a monorail data input signal D' into two dual-rail encoded signals. Wave traces of the circuit of Figure 7 are given in Figure 8.

The conversion circuit 130 comprises an inverter 132, a PMOS transistor 134, an NMOS transistor 136 and three input/output terminals 138, 140, 142.

The inverter 132 in this Figure 7 may be standard CMOS inverter of the type illustrated in Figure 1b. The PMOS transistor 134 has its source terminal connected to the conversion circuit's input data terminal 138, which carries the input data signal D', and its drain terminal connected to the drain terminal of the NMOS transistor 136. The common drain terminals of the PMOS and NMOS transistors 134, 136 form the conversion circuit's output data terminal 142 which carries the output data signal Q. The gate of the PMOS transistor 134 and the source of the NMOS transistor 136 are connected to the negative supply rail GND. The input of the inverter 132 is connected to the conversion circuit's input data terminal 138. The output of the inverter 132 is connected to the gate terminal of the NMOS transistor 136 and forms the conversion circuit's output data terminal 140 which carries the complementary output data signal QN.

The conversion circuit 130 operates to convert the single data input signal D' on the input data terminal 138 to dual data output signals Q and QN on the respective output data terminals 142, 140 in which one of the data output signals QN is the inverse of the other Q and the inverse of the data input signal D' as illustrated in Figure 8.

Figure 9 illustrates an alternative embodiment of the latch 80 of the present invention in which a pull-up circuit is used, instead of the pull-down network of Figure 3, to change the state of this embodiment 80' of the latch 80.

The latch 80' of Figure 9 comprises two inverters 150, 152, five input/output terminals 154,156,158,160,162 and three PMOS transistors 164, 166, 168.

The two inverters 150, 152 in this Figure 9 may be standard CMOS inverters of the type illustrated in Figure 1b. Inverters 150 and 152 correspond to the respective inverters 82 and 84 of Figure 3.

Referring to Figure 9, the first and second PMOS transistors 164, 166 have their respective source terminals 163 connected together. These common source terminals 163 are also connected to the drain terminal of the third PMOS transistor 168. The drain terminal of the first transistor 164 forms the output terminal 160 which carries the latch's complement data output signal QN. The drain terminal of the second PMOS transistor 166 forms the output terminal 162 which carries the latch's data output signal Q. The source terminal of the third PMOS transistor 168 is connected to the positive supply rail VDD. The two inverters 150,152 are connected in a back-to-back manner between the latches two output terminals 160,162. The respective gate terminals of the first and second PMOS transistors 164,166 respectfully correspond to the two data input terminals 154 and 156. The two data input terminals 154 and 156 respectfully carry the complementary input data signals D and DN. The gate terminal of the third PMOS transistor 168 corresponds to an input control terminal 158 which carries the control signal GN which is the complement of the enable signal G in Figure 3.

Operation of the latch 80' of Figure 9 is similar to that of the latch 80 shown in Figure 3. However, in this particular embodiment of the latch 80', D=0 and DN=0 must not occur at the same time or the content of the latch 80' will be corrupted and the latch 80' becomes transparent, i.e. enabled, when GN=0.

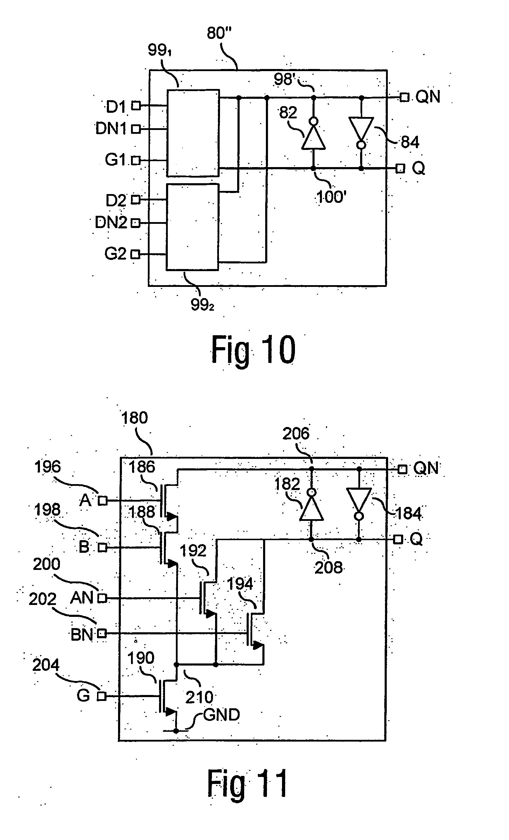

A further alternative embodiment of the present invention is shown in Figure 10.

In this latch 80" embodiment, the latch 80 of Figure 3 has been adapted to include two input circuits 99₁, 99₂ of the type shown in Figure 3. Referring to Figure 10, the respective input circuits 99₁, 99₂ have two sets of input and control signals, respectively D1, DN1, G1 and D2, DN2, G2. For simplicity, only two input circuits 99_{1,} 99₂ have been illustrated but, it can be appreciated that any number 'N' of input circuits 99 can be realized. The respective complementary data output terminals of the two input circuits 99₁, 99₂ are respectively connected together to form common complementary data output terminals 98', 100', across which back-to-back inverters 82, 84 are connected, which respectively carry the complementary data output signals QN, Q.

In this embodiment of the latch 80" a pull-down network of NMOS transistors is used as in Figure 3, but of course it can be appreciated that this latch 80" could be realized with a pull-up network of PMOS transistors 164,166,168 as shown in Figure 9.

Figure 11 illustrates an application of the static latch according to the embodiment of the present invention for carrying out a Boolean function. In this exemplary embodiment A AND B, when the enable signal G=1.

The static latch AND circuit 180 of Figure 11 comprises two inverters 182,184, five NMOS transistors 186,188,190, 192, 194 and five input/output terminals 196,198,200,202,204.

The two inverters 182,184 in this Figure 11 may be standard CMOS inverters of the type illustrated in Figure 1b. Inverters 182 and 184 correspond to the respective inverters 82 and 84 of Figure 3.

The first, second and third NMOS transistors 186, 188, 190 are respectively connected in series with each other. The fourth and fifth NMOS transistors 192,194 are respectively connected in parallel with each other.

The drain of the first NMOS transistor 186 is connected to the respective input and output terminals of the two inverters 184 and 182 and forms the complementary data output terminal 206 of the static latch AND circuit 180 which carries the complementary data output signal QN. The drain of the second NMOS transistor 188 is connected to the source of the first NMOS transistor 186. The drain 210 of the third NMOS transistor 190 is connected to the source of the second NMOS transistor 188. The source of the third NMOS transistor 190 is connected to the negative supply rail GND.

The gates of the of the respective first and second NMOS transistors 186 and 188 respectively form the data input terminals 196 and 198 of the static latch AND circuit 180 which respectively carry the data input signals A and B. The gate of the of the third transistor 190 forms the control input terminal 204 of the static latch AND circuit 180 which carries the control input signal G.

The drains of the fourth and fifth NMOS transistors 192,194 are connected to the respective input and output terminals of the two inverters 182 and 184 and forms the data output terminal 208 of the static latch AND circuit 180 which carries the data output signal Q. The sources of the fourth and fifth NMOS transistors 192,194 are both connected to the drain 210 of the third NMOS transistor 190.

The gates of the of the respective fourth and fifth NMOS transistors 192 and 194 respectively form the complementary data input terminals 202 and 204 of the static latch AND circuit 180 which respectively carry the complementary data input signals AN and BN.

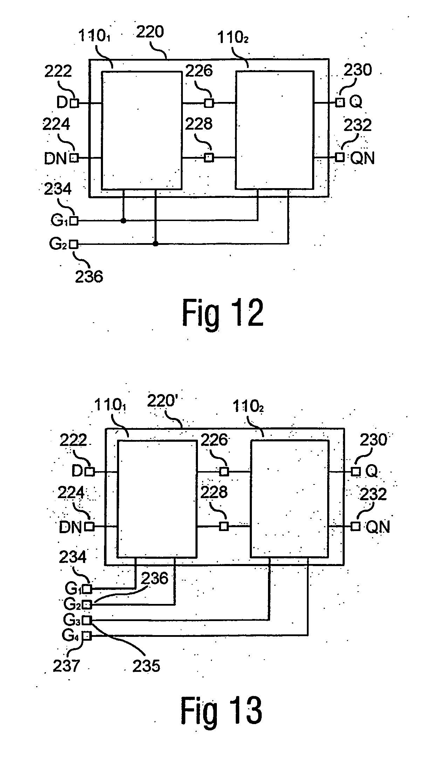

Figure 12 illustrates a chain of two simple shift-registers 110₁,110₂ according to the embodiments of the present invention.

The chain of first and second shift-registers 110₁,110₂ of the type illustrated in Figure 5 are operatively connected to form a four latch shift-register 220. Although, for the purposes of our explanation here, two shift-registers 110₁,110₂ are shown, it can be appreciated that any number 'N' of shift-registers 110 may be connected for chains of arbitrary length.

Each of the shift-registers 110₁,110₂ comprises complementary data input terminals, complementary data output terminals and dual control terminals.

The first shift-register 110₁ receives respective complementary input data signals D, DN on its respective complementary data input terminals 222, 224 and provides respective complementary output data signals on its respective complementary data output terminals 226, 228. The second shift-register 110₂ receives the respective complementary output data signals from the complementary data output terminals 226, 228 as its complementary input data signals and provides respective complementary output data signals Q, QN on its respective complementary data output terminals 230, 232. Therefore, the complementary output data signals of the first shift-register 110₁ serve as the complementary input data signals of the second shift-register 110₂. Each of the shift-registers 110₁, 110₂ receives the respective data control signals G₁ and G2 on respective data control terminals 234 and 236.

The circuit of Figure 12 behaves like a 2-bit shift-register if the waveforms of the data control signals G₁ and G₂ are non-overlapping pulses. In this way each pair of latches within the respective shift-registers 110₁, 110₂ form a master/slave flip flop.

In utilizing the latches of the embodiments of the present invention, much smaller shift-register implementations can be realized.

Referring to Figure 13, an even smaller implementation of the circuit shown in Figure 12 can be realized. Each shift-register 110₁, 110₂ of the chain are interconnected in the same way as the chain of Figure 12, except that the input control terminals of the latches that comprise the shift-registers 110₁, 110₂ are connected to four respective data control terminals 234,235,236,237 that carry the respective input data control signals G₁-G₄. These enable input control signals G₁-G₄ are non-overlapping pulses and each pulse is cascaded so that one pulse occurs after the previous one. This particular implementation provides only one slave latch per 3 bits in the chain.

Although preferred embodiments of the device of the present invention has been illustrated in the accompanying drawings and described in the forgoing detailed description, it will be understood that the invention is not limited to the embodiments disclosed, but is capable of numerous variations, modifications without departing from the scope of the invention as set out in the following claims.

## Claims

1. A static latch (80, 80', 80") for transferring at least one first input data signal and second input data signal, the second input data signal being the complement of the first input data signal, to respective first and second output terminals (98; 100, 160; 162) when the latch is enabled by an enable signal, and for maintaining a current data value on the output terminals (98; 100, 160; 162) when the latch is not so enabled, the static latch comprising:
- at least one first input terminal (92, 154) for receiving the at least one first input data signal;
- at least one second input terminal (94, 156) for receiving the at least one second input data signal;
- a control terminal (96, 158) for receiving an enable signal,
wherein the enable signal gates a first transistor (90, 168), the at least one first input data gates at least one second transistor (86, 164), and the at least one second input data gates at least one third transistor (88, 166) such that when the latch is enabled the first and second transistors (90, 168; 86, 164) transfer the first input data signal to the first output terminal (98, 160) and the first and third transistors (90, 168; 88, 166) transfer the second input data signal to the second output terminal (100, 162), the static latch further comprising a back-to-back connected inverter pair (82; 84, 150; 152, 182; 184) coupled in parallel between the first and second output terminals (98; 100, 160; 162) for maintaining the current data values on said output terminals (98; 100, 160; 162) when the latch is not so enabled and the first and second input terminals (92; 94) are disconnected from said output terminals (98; 100).

2. A static latch according to claim 1, wherein the first, second and third transistors (92; 94; 96) are nMOS transistors forming a pull down network.

3. A static latch according to claim 1, wherein the first, second and third transistors (168; 166; 164) are pMOS transistors forming a pull up network..

4. A static latch according to claim 1, wherein each of said inverters (82; 84, 150; 152) comprise a transistor of a first conductivity type and a transistor of a second conductivity type.

5. A static latch according to claim 1, wherein the first, second and third transistors (92; 94; 96, 168; 166; 164) are of a first conductivity type.

6. A static latch according to claim 5, wherein a transistor of the first conductivity type is an NMOS field effect transistor and a transistor of the second conductivity type is a PMOS field effect transistor.

7. A bistable memory cell comprising a latch according to any one of the preceding claims.

8. A shift-register comprising a plurality of latches according to any one of claim 1 to 6.

9. A memory device comprising a plurality of latches according to any one of claim 1 to 6.

10. A flip-flop comprising a plurality of latches according to any one of claim 1 to 6.

11. A static latch circuit comprising a static latch according to any one of claim 1 to 6 and a conversion circuit (130) for converting the at least one first input data into at least one dual input data signal comprising the at least one first input data and the at least one second input data.

12. A plurality of static latch circuits according to any one of claim 1 to 6 that are formed on an integrated circuit.

## Patentansprüche

1. Statisches Latch (80, 80', 80") zum Übertragen wenigstens eines ersten Eingangsdatensignals und eines zweiten Eingangsdatensignals, wobei das zweite Eingangsdatensignal das Komplement zu dem ersten Eingangsdatensignal ist, an entsprechende erste und zweite Ausgangsanschlüsse (98; 100, 160; 162), wenn das Latch durch ein Aktivierungssignal aktiviert ist, und zum Halten eines aktuellen Datenwertes an den Ausgangsanschlüssen (98; 100, 160; 162), wenn das Latch nicht auf diese Art aktiviert ist, wobei das statische Latch umfasst: - wenigstens einen ersten Eingangsanschluss (92, 154) zum Empfangen des wenigstens einen ersten Eingangsdatensignals;
- wenigstens einen zweiten Eingangsanschluss (94, 156) zum Empfangen des wenigstens einen zweiten Eingangsdatensignals;
- einen Steueranschluss (96, 158) zum Empfangen eines Aktivierungssignals,
wobei das Aktivierungssignal einen ersten Transistor (90, 168) steuert, die wenigstens einen ersten Eingangsdaten wenigstens einen zweiten Transistor (86, 164) steuern und die wenigstens einen zweiten Eingangsdaten wenigstens einen dritten Transistor (88, 166) steuern, derart, dass der erste und zweite Transistor (90, 168; 86, 164) das erste Eingangsdatensignal auf den ersten Ausgangsanschluss (98, 160) übertragen und der erste und dritte Transistor (90, 168; 88, 166) das zweite Eingangsdatensignal auf den zweiten Ausgangsanschluss (100, 162) übertragen, wenn das Latch aktiviert ist, wobei das statische Latch weiter ein Paar back-to-back verbundener Inverter umfasst, das parallel zwischen dem ersten und zweiten Ausgangsanschluss (98; 100, 160; 162) gekoppelt ist, zum Aufrechterhalten der Stromdatenwerte an den Ausgangsanschlüssen (98; 100, 160; 162), wenn das Latch nicht auf diese Art aktiviert ist und der erste und der zweite Eingangsanschluss (92; 94) von den Ausgangsanschlüssen (98; 100) getrennt sind.

2. Statisches Latch gemäß Anspruch 1, wobei der erste, zweite und dritte Transistor (92; 94; 96) nMOS-Transistoren sind, die ein Pull-down-Netzwerk bilden.

3. Statisches Latch gemäß Anspruch 1, wobei der erste, zweite und dritte Transistor (168; 166; 164) pMOS-Transistoren sind, die ein Pull-up-Netzwerk bilden.

4. Statisches Latch gemäß Anspruch 1, wobei jeder der Inverter (82; 84, 150; 152) einen Transistor eines ersten Leitfähigkeitstyps und einen Transistor eines zweiten Leitfähigkeitstyps umfassen.

5. Statisches Latch gemäß Anspruch 1, wobei der erste, zweite und dritte Transistor (92; 94; 96, 168; 166; 164) von einem ersten Leitfähigkeitstyp sind.

6. Statisches Latch gemäß Anspruch 5, wobei ein Transistor des ersten Leitfähigkeitstyps ein NMOS-Feldeffekttransistor und ein Transistor des zweiten Leitfähigkeitstyps ein PMOS-Feldeffekttransistor ist.

7. Bistabile Speicherzelle, umfassend ein Latch gemäß einem der vorangehenden Ansprüche.

8. Schieberegister, umfassend eine Vielzahl von Latches gemäß einem der Ansprüche 1 bis 6.

9. Speichervorrichtung, umfassend eine Vielzahl von Latches gemäß einem der Ansprüche 1 bis 6.

10. Flipflop, umfassend eine Vielzahl von Latches gemäß einem der Ansprüche 1 bis 6.

11. Statische Latch-Schaltung, umfassend ein statisches Latch gemäß einem der Ansprühe 1 bis 6 und eine Umwandlungsschaltung (130) zum Umwandeln der wenigstens einen ersten Eingangsdaten in wenigstens ein die wenigstens einen ersten Eingangsdaten und die wenigstens einen zweiten Eingangsdaten umfassendes duales Eingangsdatensignal.

12. Vielzahl von statischen Latch-Schaltungen gemäß einem der Ansprüche 1 bis 6, die in einer integrierten Schaltung ausgebildet sind.

## Revendications

1. Verrou statique (80, 80', 80") pour transférer au moins un premier signal de données d'entrée et un deuxième signal de données d'entrée, le deuxième signal de données d'entrée étant le complément du premier signal de données d'entrée, à des première et deuxième bornes de sortie respectives (98 ; 100, 160 ; 162) lorsque le verrou est activé par un signal d'activation, et pour maintenir une valeur de données de courant sur les bornes de sortie (98 ; 100, 160 ; 162) lorsque le verrou n'est pas activé de cette façon, le verrou statique comprenant :
- au moins une première borne d'entrée (92, 154) pour recevoir le au moins un premier signal de données d'entrée ;
- au moins une deuxième borne d'entrée (94, 156) pour recevoir le au moins un deuxième signal de données d'entrée ;
- une borne de commande (96, 158) pour recevoir un signal d'activation,
dans lequel le signal d'activation débloque un premier transistor (90, 168), la au moins une première donnée d'entrée débloque au moins un deuxième transistor (86, 164), et la au moins une deuxième donnée d'entrée débloque au moins un troisième transistor (88, 166) de sorte que lorsque le verrou est activé, les premier et deuxième transistors (90, 168 ; 86, 164) transfèrent le premier signal de données d'entrée à la première borne de sortie (98, 160) et les premier et troisième transistors (90, 168 ; 88, 166) transfèrent le deuxième signal de données d'entrée à la deuxième borne de sortie (100, 162), le verrou statique comprenant en outre une paire d'inverseurs connectés tête-bêche (82 ; 84, 150 ; 152, 182 ; 184) couplés en parallèle entre les première et deuxième bornes de sortie (98 ; 100, 160 ; 162) pour maintenir les valeurs de données de courant sur lesdites bornes de sortie (98 ; 100, 160 ; 162) lorsque le verrou n'est pas activé de cette façon et les première et deuxième bornes d'entrée (92 ; 94) sont déconnectées desdites bornes de sortie (98 ; 100).

2. Verrou statique selon la revendication 1, dans lequel les premier, deuxième et troisième transistors (92 ; 94 ; 96) sont des transistors NMOS formant un réseau de forçage au niveau logique bas.

3. Verrou statique selon la revendication 1, dans lequel les premier, deuxième et troisième transistors (168 ; 166 ; 164) sont des transistors PMOS formant un réseau de forçage au niveau logique haut.

4. Verrou statique selon la revendication 1, dans lequel chacun desdits inverseurs (82 ; 84, 150 ; 152) comprend un transistor d'un premier type de conductivité et un transistor d'un deuxième type de conductivité.

5. Verrou statique selon la revendication 1, dans lequel les premier, deuxième et troisième transistors (92 ; 94 ; 96, 168 ; 166 ; 164) sont d'un premier type de conductivité.

6. Verrou statique selon la revendication 5, dans lequel un transistor du premier type de conductivité est un transistor à effet de champ NMOS et un transistor du deuxième type de conductivité est un transistor à effet de champ PMOS.

7. Cellule de mémoire bistable comprenant un verrou selon l'une quelconque des revendications précédentes.

8. Registre à décalage comprenant une pluralité de verrous selon l'une quelconque des revendications 1 à 6.

9. Dispositif de mémoire comprenant une pluralité de verrous selon l'une quelconque des revendications 1 à 6.

10. Bascule comprenant une pluralité de verrous selon l'une quelconque des revendications 1 à 6.

11. Circuit de verrouillage statique comprenant un verrou statique selon l'une quelconque des revendications 1 à 6 et un circuit de conversion (130) pour convertir la au moins une première donnée d'entrée en au moins un double signal de données d'entrée comprenant la au moins une première donnée d'entrée et la au moins une deuxième données d'entrée.

12. Pluralité de circuits de verrouillage statiques selon l'une quelconque des revendications 1 à 6 qui sont formés sur un circuit intégré.
